# EUROPEAN PATENT APPLICATION

(11) **EP 4 440 264 A1**
(43) Date of publication of application: **02.10.2024**
(21) Application number: 24166291.5
(22) Date of filing: 26.03.2024
(51) Int. Cl.: H05K 7/14, H01R 12/72, H05K 1/14, H01R 12/73, H05K 3/36

(54) **BATTERY MANAGEMENT UNIT PROVIDED WITH STRUCTURE FOR PREVENTING SEPARATION OF CARD EDGE CONNECTOR AND THE STRUCTURE FOR PREVENTING SEPARATION OF CARD EDGE CONNECTOR**

(30) Priority: 26.03.2023 KR 20230039351; 14.07.2023 KR 20230091997
(71) Applicant: Samsung SDI Co., Ltd., Yongin-si, Gyeonggi-do 17084 (KR)
(72) Inventor: Ahn, Jaepil, 17084 Yongin-si, Gyeonggi-do (KR); Lee, Byunghyun, 17084 Yongin-si, Gyeonggi-do (KR); Lee, Woonghee, 15084 Siheung-si, Gyeonggi-do (KR)
(74) Representative: Gulde & Partner

(57) **Abstract**

A battery management unit provided with a structure for preventing separation of a card edge connector and a structure for preventing separation of a card edge connector are provided. A battery management unit provided with a structure for preventing separation of a card edge connector includes a main circuit board and a sub-circuit board assembled to the main circuit board in an upright position, in which the main circuit board includes a slot block configured for insertion of the sub-circuit board, a first pivoting member including a first pivoting lever pivotably arranged around the slot block, a catching protrusion at a side of the first pivoting lever and insertable into a recess in the sub-circuit board, and a stepped portion at another side of the first pivoting lever, and a second pivoting member pivotably arranged around the slot block to press-contact the stepped portion.

## Description

### BACKGROUND

### 1. Field

Aspects of one or more embodiments relate to a battery management unit, and a structure for preventing separation of a card edge connector.

### 2. Description of the Related Art

Battery systems generally include battery system monitors (BSMs), battery disconnect units (BDUs), and battery module monitors (BMMs). Sub-control units such as BSMs, BDUs, BMMs, etc., are configured to communicate with the battery systems through appropriate communication buses. The sub-control units may perform various functions in the battery systems. The BMMs are mounted at a battery module or sub-module level and are configured to measure a cell voltage, and, if possible, a temperature and provide cell balancing in the module. The BSMs are configured to receive voltage data from the BMMs of all battery modules and additionally control the battery systems as a whole. The BSMs are further configured to provide a communication interface outside the battery systems to communicate with electrical loads connected to the BSMs. For example, the BSMs may be connected to mother boards of the battery systems through flexible printed circuit cables (FPCs).

However, such structures in which the BSMs, the BDUs, and the BMMs are configured as separate modules and are connected to the mother boards through cables are expensive in terms of manufacturing costs, and sizes of components thereof increase. Therefore, it is desirable that a structure for directly connecting control units such as a BSM, a BDU, and a BMM to a card edge connector be improved.

### SUMMARY

According to an aspect of one or more embodiments, a battery management unit, and a structure for connecting various control modules and a mother board of a battery management unit to each other are provided. According to another aspect of one or more embodiments, a battery management unit in which a structure for connecting a main circuit board and a sub-circuit board of the battery management unit to each other is improved, thereby reducing a manufacturing cost of the battery management unit and enabling miniaturization thereof.

Additional aspects will be set forth in part in the description which follows and, in part, will be apparent from the description, or may be learned by practice of the presented embodiments of the present disclosure.

According to one or more embodiments, a battery management unit provided with a structure for preventing separation of a card edge connector includes a main circuit board and a sub-circuit board assembled to the main circuit board in an upright position, in which the main circuit board includes a slot block configured for insertion of the sub-circuit board, a first pivoting member including a first pivoting lever pivotably arranged around the slot block, a catching protrusion at a side of the first pivoting lever and insertable into a recess in the sub-circuit board, and a stepped portion at another side of the first pivoting lever, and a second pivoting member pivotably arranged around the slot block to press-contact the stepped portion.

The first pivoting member may be pivotable to an upright position for coupling with the recess in the sub-circuit board, and the second pivoting member may be pivotable to an upright position to press-contact the stepped portion of the first pivoting member in the upright position of the second pivoting member.

The second pivoting member may include a second pivoting lever arranged pivotably with respect to a second rotation shaft at an outer position with respect to a rotation shaft of the first pivoting member and a head portion that is rotatable integrally with the second pivoting lever and extends in parallel to the stepped portion in a direction intersecting the first pivoting member to face-to-face contact the stepped portion of the first pivoting member.

As the stepped portion press-contacts with the head portion, a catching protrusion at an opposite side of the stepped portion may move in a direction to increase a width overlapping width with the recess in the sub-circuit board.

The second pivoting member may further include an operating lever for fixing an upright position that forms a press-contact with the stepped portion.

The operating lever may include an operating portion at an outer end for a releasing operation and a hook at an inner end and coupled to the slot block.

The first pivoting lever or the first pivoting member may include an inclined surface configured for hook coupling with the slot block..

The inclined surface may have a slope configured to allow entry of the first pivoting lever into the slot block and prevent the first pivoting lever from leaving the slot block.

The sub-circuit board may be mounted to be attached to and detached from the main circuit board.

The main circuit board may include a plurality of slot blocks that provide mounting positions of the sub-circuit board.

According to one or more embodiments, a structure for preventing separation of a card edge connector includes a slot block configured for insertion of a sub-circuit board, a first pivoting member including a first pivoting lever pivotably arranged around the slot block, a catching protrusion at a side of the first pivoting lever and insertable into a recess in the sub-circuit board, and a stepped portion at another side of the first pivoting lever, and a second pivoting member pivotably arranged around the slot block to press-contact the stepped portion.

### BRIEF DESCRIPTION OF THE DRAWINGS

The above and other aspects, features, and advantages of certain embodiments of the present disclosure will be more apparent from the following description taken in conjunction with the accompanying drawings, in which:
FIG. 1 shows a circuit board coupling structure of a battery management unit according to an embodiment of the present disclosure;
FIG. 2 shows a three-dimensional structure of a first pivoting member shown in FIG. 1;
FIG. 3 shows a first pivoting member, shown in FIG. 2, and a second pivoting member, arranged in a slot block;
FIG. 4 is a cross-sectional view along the line IV- IV of FIG. 3;
FIG. 5 shows a state in which a hook is separated by applying an external force to an operating lever to unlock a second pivoting member shown in FIG. 3;
FIG. 6 shows a state in which a second pivoting member shown in FIG. 5 is unlocked; and
FIG. 7 shows a state in which a first pivoting member shown in FIG. 6 is unlocked.

### DETAILED DESCRIPTION

Reference will now be made in further detail to embodiments, examples of which are illustrated in the accompanying drawings, wherein like reference numerals refer to like components throughout. In this regard, the present embodiments may have different forms and should not be construed as being limited to the descriptions set forth herein. Accordingly, the embodiments are described below, by referring to the figures, to explain aspects of the present description.

Herein, some example embodiments of the present disclosure will be described in further detail with reference to the attached drawings to allow those of ordinary skill in the art to easily carry out the embodiments of the present disclosure. However, the present disclosure may be implemented in various different forms, and is not limited to the embodiments described herein. In addition, in describing embodiments of the present disclosure, if it is determined that a detailed description of a related known function or configuration may unnecessarily obscure the gist of the present disclosure, a detailed description thereof may be omitted. The same reference numerals are used for parts having the same or similar functions and actions throughout the drawings.

If a portion is referred to as "includes" a component, the portion may not exclude another component but may further include another component unless stated otherwise. More specifically, it is to be understood that the terms "comprise," "include," "have," or the like used herein indicate the presence of features, numbers, steps, operations, components, parts, or a combination thereof described in the specification, and do not preclude the presence or addition of one or more other features, numbers, steps, operations, components, parts, or a combination thereof.

Singular forms include plural forms unless indicated otherwise contextually. In addition, the shapes and sizes of components in the drawings may be exaggerated for clarity of description.

Unless otherwise defined, all terms (including technical and scientific terms) used herein have the same meaning as commonly understood by one of ordinary skill in the art to which the inventive concept pertains. It is also to be understood that terms defined in commonly used dictionaries should be interpreted as having meanings consistent with the meanings in the context of the related art, and are expressly defined herein unless they are interpreted in an ideal or overly formal sense.

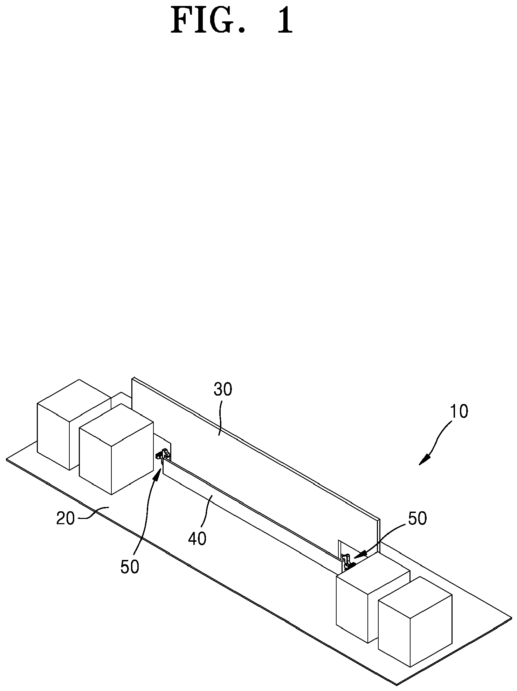

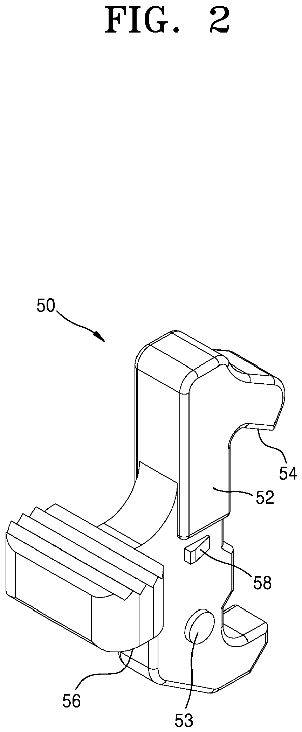

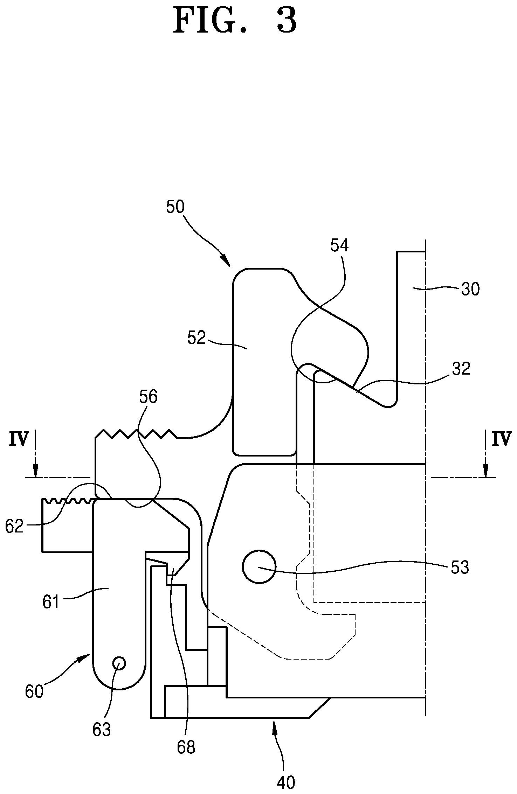

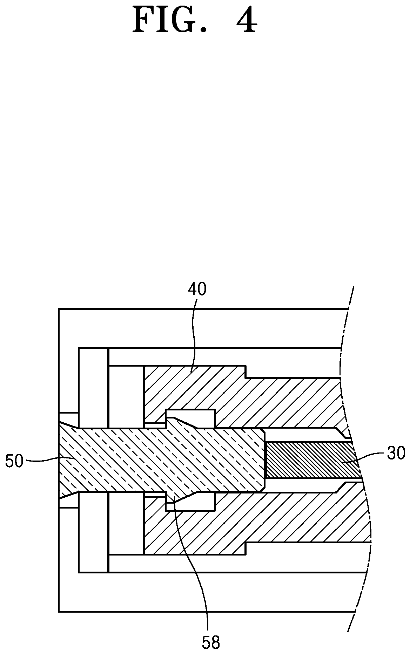

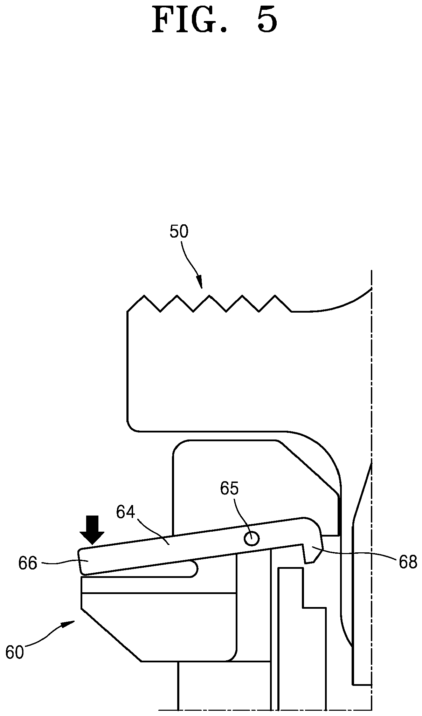

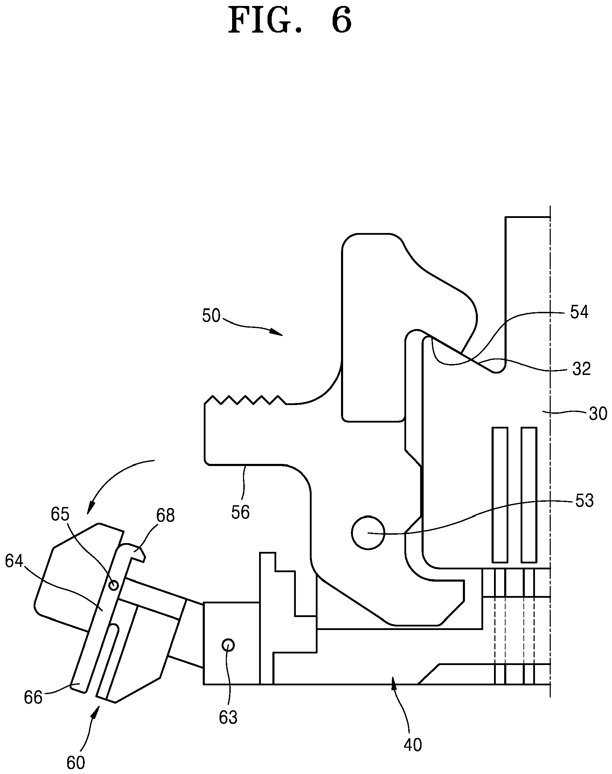

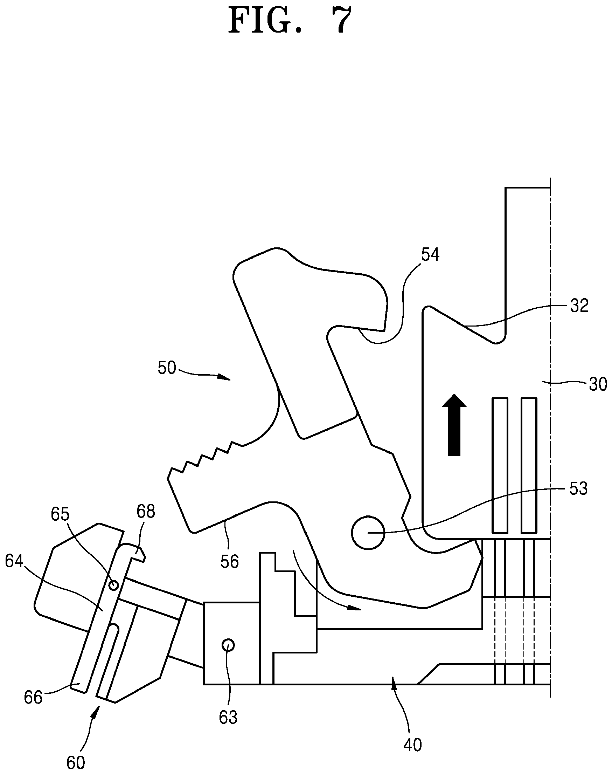

FIG. 1 shows a circuit board coupling structure of a battery management unit according to an embodiment of the present disclosure. FIG. 2 shows a three-dimensional structure of a first pivoting member shown in FIG. 1. FIG. 3 shows a state of a first pivoting member shown in FIG. 2, and a second pivoting member, being arranged in a slot block. FIG. 4 is a cross-sectional view along the line IV- IV of FIG. 3. FIG. 5 shows a state in which a hook is separated by applying an external force to an operating lever to unlock a second pivoting member shown in FIG. 3. FIG. 6 shows a state in which a second pivoting member shown in FIG. 5 is unlocked. FIG. 7 shows a state in which a first pivoting member shown in FIG. 6 is unlocked.

Referring to FIGS. 1 to 7, a battery management unit provided with a structure for preventing separation of a card edge connector (herein, referred to as a "battery management unit") 10 according to embodiments of the present disclosure may include a main circuit board 20, a sub-circuit board 30, a slot block 40, a first pivoting member 50, and a second pivoting member 60.

The main circuit board 20 may be a mother board of the battery management unit 10. The main circuit board 20 may include a circuit that controls a state of a battery by comprehensively processing data received from various sub-control units. The sub-control units may be, for example, a battery system monitor (BSM), a battery disconnect unit (BDU), a battery module monitor (BMM), etc.

The sub-circuit board 30 may be a BSM, a BDU, a BMM, etc., as described in relation to the main circuit board 20. The sub-circuit board 30 may be electrically connected to the main circuit board 20. The sub-circuit board 30 may be assembled in an upright posture relative to the main circuit board 20. The sub-circuit board 30 may include a recess 32 to be coupled to a catching protrusion 54 of the first pivoting member 50 described below.

The slot block 40 may be provided in the main circuit board 20. The slot block 40 may be a connector structure for insertion of the sub-circuit board 30. The slot block 40 may be electrically connected to the main circuit board 20. The slot block 40 may include a connector electrically connected to the sub-circuit board 30.

The first pivoting member 50 may be arranged around the slot block 40. For example, the first pivoting member 50 may be provided at opposite end sides of the slot block 40. The first pivoting member 50 may include a first pivoting lever 52, the catching protrusion 54, and a stepped portion 56. The face of the first pivoting member 50 facing the sub-circuit board 30 may have the shape of a bracket into which parts of the sub-circuit board 30 including the recess 32 are inserted. The bracket may be provided to restrict movement of the first pivoting member 50 during locking and unlocking.

The first pivoting lever 52 may be arranged rotatably with respect to the slot block 40. The first pivoting lever 52 may be arranged rotatably around a first rotation shaft 53 disposed in a width direction of the slot block 40, for example.

The catching protrusion 54 may be formed at a side of the first pivoting lever 52. The catching protrusion 54 may be inserted into the recess 32 of the sub-circuit board 30 in a locked state.

The first pivoting member 50 may pivot to an upright position for coupling with the recess 32 of the sub-circuit board 30. In a state of the first pivoting member 50 pivoting to the upright position, the catching protrusion 54 may be inserted into or interfere with the recess 32.

The stepped portion 56 may be formed at another side of the first pivoting lever 52. The stepped portion 56 may also serve as a handle for applying an external force in locking and unlocking the first pivoting member 50. The stepped portion 56 may be a locking portion configured for preventing or substantially preventing the first pivoting member 50 from being unlocked by the second pivoting member 60 described later.

The second pivoting member 60 may be arranged rotatably around the slot block 40. The second pivoting member 60 may press-contact the stepped portion 56. The second pivoting member 60 may include a second pivoting lever 61, a head portion 62, and an operating lever 64.

The second pivoting lever 61 may be arranged rotatably with respect to a second rotation shaft 63. The second rotation shaft 63 may be disposed at an outer position with respect to the first rotation shaft 53. In this regard, the term "outer position" may refer to a location further spaced apart from the sub-circuit board 30.

The head portion 62 may be rotated integrally with the second pivoting lever 61. The head portion 62 may be disposed at an upper end of the second pivoting lever 61. The head portion 62 may be disposed to contact face-to-face with the stepped portion 56 of the first pivoting member 50 and may realize a form-fit with stepped portion 56. The head portion 62 may form a contact surface extending in parallel to the stepped portion 56 in a direction intersecting with the first pivoting member 50.

The second pivoting member 60 may pivot to the upright position to press-contact the stepped portion 56 of the first pivoting member 50 in the upright position.

Due to the press-contact between the stepped portion 56 and the head portion 62, the first pivoting member 50 may pivot to at least a position close to a right upright position.

Due to the press-contact between the stepped portion 56 and the head portion 62, the catching protrusion 54 formed at the opposite side of the stepped portion 56 may move in a direction to increase a width overlapping with the recess 32 of the sub-circuit board 30.

The operating lever 64 may be provided in the second pivoting member 60. The operating lever 64 may fix the upright position at which the second pivoting member 60 forms a press-contact with the stepped portion 56. For example, the operating lever 64 may be arranged on the second pivoting member 60 to pivot in the form of a seesaw with respect to a third rotation shaft 65. The operating lever 64 may be arranged such that a hook 68 described later may be pressed by a spring (not shown) in a direction to be caught in the slot block 40.

The operating lever 64 may include an operating portion 66 and the hook 68.

The operating portion 66 may be formed on an outer or distal end of the operating lever 64. The operating portion 66 may apply an external force to unlock the second pivoting member 60.

The hook 68 may be formed on an inner end of the operating lever 64. The hook 68 may be a structure, for example, in the form of a hook coupled to the slot block 40. The hook 68 may be coupled to the slot block 40 to prevent or substantially prevent the second pivoting member 60 from rotating with respect to the second rotation shaft 63.

The first pivoting lever 52 of the first pivoting member 50 may be provided with an inclined surface 58. The inclined surface 58 may form hook coupling of the first pivoting lever 52 with the slot block 40. In an embodiment, the inclined surface 58 may have a slope allowing entry of the first pivoting lever 52 into the slot block 40 and preventing or substantially preventing the first pivoting lever 52 from leaving the slot block 40. In an embodiment, a pair of inclined surfaces 58 may be provided.

The sub-circuit board 30 may be mounted to be attached to or detached from the main circuit board 20. The sub-circuit board 30 may be attached to and detached from the main circuit board 20 in a state in which both the locked state of the first pivoting member 50 and the locked state of the second pivoting member 60 are released.

The main circuit board 20 may include a plurality of slot blocks 40 that provide mounting positions of the sub-circuit board 30. For example, two or more slot blocks 40 may be included.

Herein, working effects of the battery management unit 10 including the above-described components will be described in further detail with an example of a process of assembling and separating the sub-circuit board 30 and the main circuit board 20.

First, a process of assembling the sub-circuit board 30 to the main circuit board 20 will be described. The first pivoting member 50 and the second pivoting member 60, which are pivotably arranged in the slot block 40, may be in unlocked states. Then, the sub-circuit board 30 may be moved downward toward the slot block 40 from above the slot block 40. In an embodiment, a lower edge of the sub-circuit board 30 may be provided with a plurality of connector pads. In a state in which the sub-circuit board 30 contacts the slot block 40, the sub-circuit board 30 may be pressed to be inserted into the slot block 40. Now, the sub-circuit board 30 may be electrically connected to the main circuit board 20. The sub-circuit board 30 may come into contact with a lower end of the first pivoting member 50, which may be formed as a hook, such that the first pivoting member 50 may be rotated to an upright position to insert the catching protrusion 54 into the recess 32. In this process, the inclined surface 58 provided in the first pivoting member 50 may enter the slot block 40 to form the hook coupling with the slot block 40. In an embodiment, the inclined surface 58 may include a slope in the form of an arrowhead and may be configured to prevent or substantially prevent the first pivoting member 50 coupled to the slot block 40 from leaving the slot block 40. In this case, primarily, the sub-circuit board 30 may be prevented or substantially prevented from being separated from the slot block 40 by coupling between the catching protrusion 54 and the recess 32. In this state, the second pivoting member 60 may be rotated to the upright position. The second pivoting member 60 may be rotated such that a top surface of the head portion 62 presses a bottom surface of the stepped portion 56. The second pivoting member 60 may be configured to prevent or substantially prevented from leaving the slot block 40, as the hook 68 formed in the inner end of the operating lever 64 is caught by the slot block 40. The first pivoting member 50 may be prevented or substantially prevented from being unlocked by the second pivoting member 60. As such, the first pivoting member 50 and the second pivoting member 60 may cooperate with each other, thereby effectively preventing or substantially preventing the sub-circuit board 30 from being separated from the slot block 40.

Next, a process of separating the sub-circuit board 30 from the slot block 40 to replace or repair the sub-circuit board 30 will be described.

First, the second pivoting member 60 is switched to the unlocked state. By applying an external force to the operating lever 64, the hook 68 may leave a catching groove portion of the slot block 40. In this state, the second pivoting member 60 may be rotated in a direction opposite to an assembling direction. The head portion 62 of the second pivoting member 60 may be separated from the stepped portion 56. Then, the first pivoting member 50 may be rotated in a direction opposite to the assembling direction. As the first pivoting member 50 rotates, the catching protrusion 54 may leave the recess 32. Now, the external force may be applied to the sub-circuit board 30 to separate the sub-circuit board 30 from the slot block 40.

In this way, the first pivoting member 50 and the second pivoting member 60 may be switched to the unlocked state, and the sub-circuit board 30 may be separated from the main circuit board 20.

As described above, in the battery management unit according to one or more embodiments of the present disclosure, the first pivoting member may be configured to primarily prevent or substantially prevent the sub-circuit board from leaving the slot block and the second pivoting member may secondarily be configured to prevent or substantially prevent coupling of the first pivoting member with the sub-circuit board from being released, thereby maintaining a stable connection structure in a structure in which the sub-circuit board is connected to the main circuit board through the card edge connector.

Further, in the battery management unit according to one or more embodiments of the present disclosure, the control unit, such as the BSM, the BDU, etc., is directly coupled to the main board without a cable, thereby saving a manufacturing cost and allowing the battery management unit to be manufactured with a small size.

Herein, the present disclosure has been described in with respect to some example embodiments, but the present disclosure is not limited to the above embodiments, and it will be apparent to those of ordinary skill in the art that many variations are possible within the scope of the present disclosure.

In the battery management unit according to the present disclosure, the first pivoting member may primarily prevent the sub-circuit board from leaving the slot block and the second pivoting member may secondarily prevent coupling of the first pivoting member with the sub-circuit board from being released, thereby maintaining a stable connection structure in a structure where the sub-circuit board is connected to the main circuit board through the card edge connector.

Moreover, in the battery management unit according to the present disclosure, the control unit such as the BSM, the BDU, etc., is directly coupled to the main board without a cable, thereby saving a manufacturing cost and allowing the battery management unit to be manufactured with a small size.

It is to be understood that embodiments described herein should be considered in a descriptive sense and not for purposes of limitation. Descriptions of features or aspects within each embodiment should typically be considered as available for other similar features or aspects in other embodiments. While one or more embodiments have been described with reference to the figures, it is to be understood by those of ordinary skill in the art that various changes in form and details may be made therein without departing from the scope of the present disclosure as set forth by the following claims.

## Claims

1. A battery management unit (10) comprising:
a main circuit board (20); and
a sub-circuit board (30) assembled perpendicular to the main circuit board (20) in an upright position,
wherein the main circuit board (20) comprises:
a slot block (40) configured for insertion of the sub-circuit board (30);
a first pivoting member (50) comprising a first pivoting lever (52) pivotably arranged with respect to the slot block (40), a catching protrusion (54) at and end of the first pivoting lever (52) and insertable into a recess (32) in the sub-circuit board (30), and a stepped portion (56) at another end of the first pivoting lever (52); and
a second pivoting member (60) pivotably arranged with respect to the slot block (40) to press-contact the stepped portion (56).

2. The battery management unit (10) as claimed in claim 1, wherein the first pivoting member (50) is arranged pivotable to an upright position for coupling with the recess (32) in the sub-circuit board (30), and
the second pivoting member (60) is arranged pivotable to an upright position to press-contact the stepped portion (56) of the first pivoting member (50) in the upright position of the second pivoting member (60).

3. The battery management unit (10) as claimed in claim 1, wherein the second pivoting member (60) comprises a second pivoting lever (61) arranged pivotably with respect to a second rotation shaft (63) in an outer position with respect to a first rotation shaft (53) of the first pivoting member (50) and a head portion (62) that is arranged rotatable integrally with the second pivoting lever (61) and arranged to extend in parallel to the stepped portion (56) in a direction intersecting the first pivoting member (50) to form-fittingly contact the stepped portion (56) of the first pivoting member (50).

4. The battery management unit (10) as claimed in claim 3, wherein the first pivoting member (50) is arranged pivotable to at least a position close to a right upright position in a configuration where the stepped portion (56) and the head portion (62) press-contact each other.

5. The battery management unit (10) as claimed in claim 4, wherein, in a configuration where the stepped portion (56) press-contacts the head portion (62), a catching protrusion (54) formed at an opposite side of the stepped portion (56) is configured to move in a direction to increase a width overlapping with the recess (32) in the sub-circuit board (30).

6. The battery management unit (10) as claimed in claim 3 or 4, wherein the second pivoting member (60) further comprises an operating lever (64) to fix an upright position that forms a press-contact with the stepped portion (56).

7. The battery management unit (10) as claimed in claim 6, wherein the operating lever (64) comprises an operating portion (66) at a distal end configured for a releasing operation and a hook (48, 68) formed at an proximal end with respect to the slot block (40) and coupled to the slot block (40).

8. The battery management unit (10) as claimed in claim 7, wherein the first pivoting lever (52) or the first pivoting member (50) comprises an inclined surface (58) configured for hook coupling with the slot block (40).

9. The battery management unit (10) as claimed in claim 8, wherein the inclined surface (58) has a slope configured to allow entry of the first pivoting lever (52) into the slot block (40) and prevent the first pivoting lever (52) from leaving the slot block (40).

10. The battery management unit (10) as claimed in any one of the previous claims, wherein the sub-circuit board (30) is mounted to be attached to and detached from the main circuit board (20).

11. The battery management unit (10) as claimed any one of the previous claims, wherein the main circuit board (20) comprises a plurality of slot blocks (40) that provide mounting positions of the sub-circuit board (30).

12. The battery management unit (10) as claimed any one of the previous claims, wherein a face of the first pivoting member (50) facing the sub-circuit board (30) comprises a bracket into which parts of the sub-circuit board (30) including the recess (32) are insertable.

13. A structure for preventing separation of a card edge connector, the structure comprising:
a slot block (40) configured for insertion of a sub-circuit board (30);
a first pivoting member (50) comprising a first pivoting lever (52) pivotably arranged around the slot block (40), a catching protrusion (54) at an end of the first pivoting lever and insertable into a recess (32) in the sub-circuit board (30), and a stepped portion (56) at another end of the first pivoting lever (52); and
a second pivoting member (60) pivotably arranged with respect to the slot block (40) to press-contact the stepped portion (56).

14. The battery management unit of claim 1 or the structure of claim 13, wherein the end of the first pivoting lever (52) where the catching protrusion (54) is located is proximal to the sub-circuit board (30), and the end of the first pivoting lever where the stepped portion (56) is provided is distal to the sub-circuit board.
